# EUROPÄISCHE PATENTANMELDUNG

(11) **EP 0 543 028 A1**
(43) Veröffentlichungstag der Anmeldung: **26.05.1993**
(21) Anmeldenummer: 91118077.6
(22) Anmeldetag: 23.10.1991
(51) Int. Cl.: H02J 13/00

(54) **Verfahren zum Erzeugen eines frequenzstabilen Signals bei einem Gerät eines Energieversorgungsnetzes, sowie eine Anordnung zur Synchronisierung und eine Empfangseinrichtung hierzu**

(71) Anmelder: SIEMENS AKTIENGESELLSCHAFT, D-80333 München (DE); SLE-Scheuvens-Lass-Elektronik, D-47506 Neukirchen-Vluyn (DE)
(72) Erfinder: Noetzel, Klaus, Dipl.-Ing., W-4100 Duisburg (DE); Lass, Klaus, Dipl.-Ing., W-4100 Duisburg (DE); Schulte, Reinhold, Dipl.-Ing., W-8520 Erlangen (DE)
(74) Vertreter: Fuchs, Franz-Josef, Dr.-Ing.

(57) **Zusammenfassung**

Um eine verbesserte Synchronisierung bei einem Gerät (5), insbesondere eines Rundsteuergerätes, zu erzielen wird vorgeschlagen, derart zu verfahren, daß ein Sendesignal eines Satellitensenders (9) als Basis-Signal zum Erzeugen eines Synchronisiersignals verwendet wird. Bevorzugt gehört der Satellitensender (9) dem Global Positioning System (GPS) an. Weiterhin werden eine Anordnung und eine Empfangseinrichtung hierzu vorgeschlagen.

## Beschreibung

Bei elektronischen Geräten eines Energieversorgungsnetzes ist es bekannt, diese mit einem Zeitsignal zu synchronisieren. Dies kann beispielsweise Geräte betreffen, die eine Zeitkennung aufweisen, z.B. Störschreibung oder leittechnische Einrichtungen, oder Einrichtungen, die eine sehr genaue Frequenz aufweisen. Hierzu gehören beispielsweise auch Rundsteueranlagen. Diese weisen eine Leitfrequenz zwischen 110 und 1600 Hz auf. Die Anforderungen an die Frequenz- und Phasenkonstanz sind hierbei sehr hoch.

Zur Synchronisierung solcher elektronischen Geräte ist es bekannt, beispielsweise das Zeitzeichen des Zeitsignal- und Normalfrequenzsenders DCF 77 zu verwenden. Für eine hochgenaue Synchronisation ist jedoch dessen Modulationsverfahren (Amplitudenmodulation) nicht geeignet. Dieses Verfahren läßt bei zeitlich und örtlich stark schwankenden Störbeeinflussungen keinen Empfang der gesendeten Zeitmarken mit der geforderten Stabilität zu.

Seit einigen Jahren wird beim DCF 77 Sender ein neues Modulationsverfahren mit pseudozufälligem Phasenrauschen angewendet. Dies hat zwar zu einer erheblichen Verbesserung geführt, erlaubt aber immer noch nicht einen Empfang der Zeitsignale mit der benötigten Konstanz und Zuverlässigkeit.

Der Erfindung liegt die Aufgabe zugrunde, eine Lösung anzugeben, mit deren Hilfe eine verbesserte Synchronisierung für ein Gerät eines Energieversorgungsnetzes möglich ist.

Der Erfinder stellte fest, daß die vorhandenen Störungen beim DCF 77 Sender an der ungünstigen Lage des Senders lagen, worauf er zu der erfindungsgemäßen Lösung gelangte.

Die Lösung der Aufgabe gelingt mit den Merkmalen des Anspruches 1. Auf diese Weise ist eine exakte Synchronisierung auch unter ungünstigen lagebedingten Empfangsbedingungen möglich. Eine ungünstige Lage kann z.B. auch durch die abschirmende Wirkung eines Schaltanlagen- oder Kraftwerkgebäudes oder von Hochspannungsleitungen gegeben sein. Die vorgeschlagene Lösung ist gegenüber der bisherigen Lösung wesentlich sicherer und zudem genauer. Bevorzugt ist der Satellitensender dem Global Positioning System (GPS) zugeordnet. Auf diese Weise steht ein hochpräzises Basis-Signal zur Verfügung, das zudem flächendeckend arbeitet.

Bevorzugt werden als Basis-Signal die als Positionierungssignale dienenden Sendesignale zumindest zweier Satellitensender verwendet. Die Sendesignale derartiger Satellitensender, insbesondere die des GPS, lassen eine hochpräzise Navigation zu. Als Nebeneffekt können die Signale jedoch auch zur Synchronisation genutzt werden. Für Präzisionsanwendungen werden bevorzugt die Signale dreier Sender ausgewertet. Ein derart erzeugtes Synchronisiersignal weist eine hochstabile Frequenz und eine große Phasengenauigkeit auf. Das elektronische Gerät kann ein Rundsteuergerät oder ein Gerät der Sekundärtechnik von Schaltanlagen, z.B. ein Schutzgerät oder ein leittechnisches Gerät, sein. Auf diese Weise ist eine wesentliche Verbesserung des Betriebes des Energieversorgungsnetzes möglich. Das Signal kann auch eine Zeitinformation enthalten. Dadurch ist eine genauere Fehleranalyse im Fehlerfall gegeben. Eine weitere Lösung der Aufgabe ist mit einer Anordnung gemäß den Merkmalen des Anspruch 8 gegeben. Noch eine weitere Lösung ist durch eine Empfangseinrichtung gemäß Anspruch 17 gegeben.

Vorteilhafte Ausgestaltungen der Lösungen ergeben sich aus den übrigen Unteransprüchen.

Weitere Vorteile und Ausgestaltungen der Erfindung werden nachfolgend anhand der Zeichnung beispielhaft näher erläutert. Es zeigt:

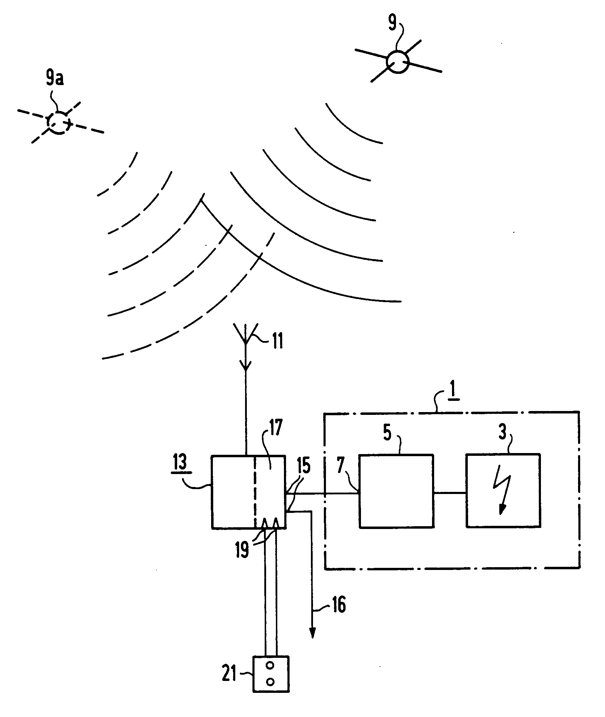

FIG 1 eine Anordnung zur Synchronisierung.

Ein Energieversorgungsnetz 1 umfaßt die für seinen Betrieb erforderlichen Betriebsmittel 3. Dies können z.B. Stromerzeuger, Hoch-, Mittel- und Niederspannungsleitungen, Leistungstransformatoren oder Schaltanlagen, sowie die dazugehörigen Hilfseinrichtungen sein. In Energieversorgungsnetzen werden zunehmend immer mehr elektronische Einrichtungen und Geräte 5, insbesondere digitale Geräte oder Rechner, eingesetzt, welche sehr genaue Zeit- oder Quarzoszillatoren enthalten. Diese Geräte können auch der sogenannten Sekundärtechnik zugeordnet sein. Darunter werden beispielsweise Schutz- Leittechnik- oder Diagnosegeräte verstanden. Für derartige Geräte ist es wichtig, eine genaue Oszillatorfrequenz aufzuweisen, um einerseits bestimmte Ereignisse im Energieversorgungsnetz mit einer genauen Zeitkennung zu versehen, oder um verschiedene elektronische Geräte miteinander zu synchronisieren.

Das beispielhaft für derartige Einrichtungen gezeigte Gerät 5 weist dazu einen Eingang 7 auf, der für die Eingabe eines Signales dient. Das Signal selbst kann dabei als elektronisches Signal (Impuls- oder Wechselsignal) oder auch als Dateninformation vorgegeben sein. Die Ausbildung des Eingangs 7, z.B. als serielles oder paralleles Interface oder nur als einfacher Impulseingang, erfolgt nach dem Fachmann allgemein bekannten Methoden.

Bei dem vorgeschlagenen Verfahren wird zur Sychronisierung ein Sendesignal eines Satellitensenders 9 als Basis- oder Ausgangssignal verwendet. Da derartige Sender aus einer großen Höhe senden, sind Einflüsse auf dem Empfang der Signale durch Lage oder Bebauung weitgehend reduziert. Das Sendesignal des Satellitensenders 9 wird dabei von einer Antenne 11 einer Empfangseinrichtung 13 aufgenommen. Das empfange Sendesignal wird dann von der Empfangseinrichtung 13 demoduliert und derart aufbereitet, daß an dessen Ausgang 15 ein dem elektronischen Gerät 5 zuführbares Signal zur Verfügung steht. Das Signal kann dabei als reines Synchronisiersignal, z.B. Impulssignal, oder als Leitfrequenz ausgebildet sein. Bei der Ausbildung als Leitfrequenz, z.B. für ein Rundsteuergerät, erfolgt im Gerät 5 quasi lediglich eine Leistungsumsetzung für das Energieversorgungsnetz. Über eine Leitung 16 kann das Signal auch an weitere zu synchronisierende Geräte geleitet werden.

Sollte die Empfangseinrichtung 13 aus handelsüblichen Komponenten aufgebaut sein, so kann diese auch einen Umsetzer 17 zur Anpassung des Signals an den Eingang 7 des elektronischen Gerätes 5 umfassen. Gegebenenfalls kann die Empfangseinrichtung 13 bzw. deren Umsetzer 17 einen Eingang 19 und/oder einen Einsteller 21 aufweisen, so daß Eingaben (ferngesteuert oder vor Ort von Hand), z.B. für einen Laufzeitausgleich oder für die Phasenlage einer Leitfrequenz, gemacht werden können. Der Umsetzer 17 kann dabei eine Regeleinrichtung und/oder einen Quarzoszillator aufweisen.

Bevorzugt werden als Basis-Signal Sendesignale verwendet, die eine Frequenz über 1000 MHz aufweisen und/oder Positionierungssignale sind. Bei Positionierungssignalen sind Sendesignale zumindest zweier Satelliten (bevorzugt dreier) erforderlich. Auf diese Weise kann auch die genaue Phasenlage des Sendesignals bestimmt werden, wodurch die Synchronisierung nochmals verbessert ist. Derartige Sendesignale sind hochpräzise und lassen eine genaue Synchronisierung der hier vorgesehenen elektronischen Geräte zu. Dabei ist der Satellitensender 9 bevorzugt dem Global Positioning System (GPS) zugeordnet. Eine auf das GPS abgestimmte Empfangseinrichtung 13 (GPS-Empfänger) liefert Zeitmarken mit einer Genauigkeit von ca. 50 bis zu 100 ns, aus denen im GPS-Empfänger bzw. im Umsetzer 17 beliebige Frequenzen, Zeitraster und Zeitinformationen erzeugt werden können, welche auf das jeweilige elektronische Gerät 5 abgestimmt sind.

Eine spezielle Anwendung kann z.B. die Synchronisierung von Rundsteuergeräten sein. Diese müssen oft über größere Entfernungen von einer Leitzentrale frequenz- phasen- und sendetaktsynchron angesteuert werden. Mit dem vorgeschlagenen Verfahren und der zugehörigen Anordnung kann auf einfache Weise eine präzise Synchronität der miteinander arbeitenden Geräte 5 erzielt werden.

## Patentansprüche

1. Verfahren zum Erzeugen eines frequenzstabilen Signals bei einem Gerät (5), insbesondere eines Rundsteuergerätes, eines Energieversorgungsnetzes (1), wobei als Basis-Signal mindestens ein Sendesignal zumindest eines Satellitensenders (9, 9a) verwendet wird.

2. Verfahren nach Anspruch 1, wobei als Basis-Signal zumindest zwei als Positionisierungssignale dienenden Sendesignale zumindest zweier Satellitensender (9,9a) verwendet werden.

3. Verfahren nach Anspruch 1 oder 2, wobei das oder die Sendesignale eine Frequenz über 1000 MHz aufweisen.

4. Verfahren nach einem der Ansprüche 1 bis 3, wobei der oder die Satellitensender (9) dem Global Positioning System (GPS) zugeordnet sind.

5. Verfahren nach einem der Ansprüche 1 bis 4, wobei das Gerät (5) einen Rechner mit Oszillator umfaßt.

6. Verfahren nach einem der Ansprüche 1 bis 5, wobei das Gerät (5) ein Rundsteuergerät oder ein Gerät der Sekundärtechnik ist.

7. Verfahren nach einem der Ansprüche 1 bis 6, wobei das oder die Signale als Synchronisiersignal oder als Leitfrequenz dient.

8. Anordnung zur Synchronisierung eines Gerätes (5) eines Energieversorgungsnetzes (1) mit einer Schaltungsanordnung zum Erzeugen eines frequenzstabilen Signals aus mindestens einem Sendesignal zumindest eines Satellitensenders (9,9a).

9. Anordnung nach Anspruch 8, wobei die Sendesignale Positionierungssignale zumindest zweier Satellitensender (9,9a) sind.

10. Anordnung nach Anspruch 8 oder 9, wobei das oder die Sendesignale eine Frequenz über 1000 MHz aufweisen.

11. Anordnung nach einem der Ansprüche 8 bis 10, wobei der oder die Satellitensender (9) dem Global Positioning System (GPS) zugeordnet sind.

12. Anordnung nach einem der Ansprüche 8 bis 11, wobei das Gerät (5) einen Rechner mit Oszillator, insbesondere Quarzozillator, umfaßt.

13. Anordnung nach einem der Ansprüche 8 bis 12, wobei das Gerät (5) ein Rundsteuergerät oder ein Gerät der Sekundärtechnik ist.

14. Anordnung nach einem der Ansprüche 8 bis 13, wobei die Schaltungsanordnung einen Umsetzer (17) zum Anpassen des empfangenen Sendesignals an einen Signaleingang des Gerätes (5) umfaßt.

15. Anordnung nach einem der Ansprüche 8 bis 14, wobei der Umsetzer (17) einen Quarzoszillator, eine Regeleinrichtung sowie Eingabemittel (19,21) zum Einstellen von Phasenlage und/oder Laufzeitparameter umfaßt.

16. Anordnung nach einem der Ansprüche 8 bis 15, wobei das Signal als Leitsignal für das Gerät (5) dient.

17. Empfangseinrichtung für ein Sendesignal zumindest eines Satellitensenders (9), das zur Synchronisierung eines Gerätes (5) eines Energieversorgungsnetzes (1) verwendet wird.
